# EUROPÄISCHE PATENTANMELDUNG

(11) **EP 4 178 069 A1**
(43) Veröffentlichungstag der Anmeldung: **10.05.2023**
(21) Anmeldenummer: 22195888.7
(22) Anmeldetag: 15.09.2022
(51) Int. Cl.: H02J 7/00, B60L 53/16, G01R 27/20, G01R 31/36

(54) **VERFAHREN ZUM ANALYSIEREN DER KONTAKTBELEGUNG EINES KONTAKTELEMENTS EINES ZELLMODULS FÜR EINEN FAHRZEUGAKKU SOWIE MODULLADEGERÄT MIT EINER DIAGNOSEFUNKTION DER KONTAKTBELEGUNG EINES KONTAKTELEMENTS**

(30) Priorität: 04.11.2021 DE 102021128766
(71) Anmelder: TKR Spezialwerkzeuge GmbH, 58285 Gevelsberg (DE)
(72) Erfinder: Herzog, Martin, 58135 Hagen (DE)
(74) Vertreter: Kalkoff & Partner Patentanwälte mbB

(57) **Zusammenfassung**

Die Erfindung betrifft ein Verfahren zum Analysieren der Kontaktbelegung eines Kontaktelements eines Zellmoduls für einen Fahrzeugakku zum nachfolgenden Laden oder Entladen einzelner Zellen des Zellmoduls mittels eines Modulladegeräts sowie ein Modulladegerät zum Laden und/oder Entladen eines Zellmoduls eines Fahrzeugakkus mit einer Diagnosefunktion der Kontaktbelegung eines Kontaktelements des Zellmoduls. Um ein Modulladegerät für Zellmodule eines Fahrzeugakkus sowie ein Verfahren zum Betrieb eines solchen Modulladegeräts bereitzustellen, das einen allgemeinen Einsatz zum Laden und Entladen von Zellen zahlreicher unterschiedlicher Zellmodule mit unterschiedlichen Kontaktbelegungen des Kontaktelements des Zellmoduls erlaubt und automatisch eine Fehlbedienung ausschließt sowie zugleich die Investitionskosten einer Werkstatt in Modulladegeräte signifikant senkt, ist zunächst ein Verbinden eines mit dem Kontaktelement des Zellmoduls korrespondierenden Kontaktelements einer Diagnoseeinheit zum Herstellen einer elektrischen Verbindung zu jedem der Kontakte des Zellmoduls vorgesehen, wobei nachfolgend wenigstens eine Spannungsmessung eines Kontaktes gegen alle anderen einzelnen Kontakte des Kontaktelements des Zellmoduls und Abspeichern der den Kontakten zugeordneten Spannungswerte durchgeführt wird. Auf Basis der den Kontakten zugeordneten Spannungswerten wird dann die Kontaktbelegung des Kontaktelements bezüglich der Verbindung zu den einzelnen Zellen des Zellmoduls ermittelt und schließlich wird das Zellmodul geladen oder entladen.

## Beschreibung

Die Erfindung betrifft ein Verfahren zum Analysieren der Kontaktbelegung eines Kontaktelements eines Zellmoduls für einen Fahrzeugakku zum nachfolgenden Laden oder Entladen einzelner Zellen des Zellmoduls mittels eines Modulladegeräts sowie ein Modulladegerät zum Laden und/oder Entladen eines Zellmoduls eines Fahrzeugakkus mit einer Diagnosefunktion der Kontaktbelegung eines Kontaktelements des Zellmoduls.

Die Akkus elektrisch angetriebener Fahrzeuge sind typischerweise aus einzelnen Akkuzellen gebildet, die in Serie verbunden in Zellmodulen gebündelt werden, wobei ein Fahrzeugakku typischerweise aus zahlreichen Zellmodulen gebildet ist. Bei einem Defekt einzelner Zellen kann so leicht das betreffende Zellmodul ausgebaut, ausgetauscht oder repariert und anschließend wieder mit dem Fahrzeugakku elektrisch verbunden werden.

Bevor jedoch der Akku wieder genutzt werden kann, muss nach einem Austausch von Zellen sichergestellt sein, dass alle Zellen des Zellmoduls und alle Zellmodule die gleiche Spannung bzw. den gleichen Ladezustand haben. Entsprechend ist ein Messen der Zellspannung der einzelnen Zellen sowie ein Laden bzw. ein Entladen einzelner Zellen, insbesondere der neu eingebauten Zellen, notwendig, was mittels eines Modulladegeräts erfolgen kann.

Der elektrische Anschluss eines solchen Modulladegeräts sowie die elektrische Verbindung der Zellmodule im Fahrzeugakku erfolgt typischerweise mittels eines standardisierten Steckers eines Zell-Kontaktierungs-Systems. Jedoch weicht die Belegung der einzelnen Kontakte des Steckers nicht nur von Hersteller zu Hersteller, sondern sogar bei einem Hersteller häufig von Fahrzeugtyp zu Fahrzeugtyp und teils sogar bei verschiedenen Versionen eines Fahrzeugtyps voneinander ab, sodass für jeden Fahrzeugtyp wenigstens ein spezifisches Adapterkabel und gegebenenfalls sogar ein spezifisches Modulladegerät notwendig ist.

Gerade in Werkstätten, die Fahrzeuge zahlreicher Hersteller reparieren, müssten somit zahlreiche Modulladegeräte bereitgestellt werden, um die unterschiedlichen Fahrzeuge reparieren zu können. Zudem besteht die Gefahr, dass ein falsches Verbindungskabel verwendet wird, das wenigstens zu einer Verschlechterung der Balance der Ladung und im schlimmsten Fall zu einer Tiefentladung einzelner Zellen und somit zu einer erneuten Beschädigung des Fahrzeugakkus führen kann.

Der Erfindung liegt daher die Aufgabe zugrunde, ein Modulladegerät für Zellmodule eines Fahrzeugakkus sowie ein Verfahren zum Betrieb eines solchen Modulladegeräts bereitzustellen, das einen allgemeinen Einsatz zum Laden und Entladen von Zellen zahlreicher unterschiedlicher Zellmodule mit unterschiedlichen Kontaktbelegungen des Kontaktelements des Zellmoduls erlaubt und automatisch eine Fehlbedienung ausschließt sowie zugleich die Investitionskosten einer Werkstatt in Modulladegeräte signifikant senkt.

Die Aufgabe wird erfindungsgemäß durch ein Verfahren zum Analysieren der Kontaktbelegung eines Kontaktelements eines Zellmoduls gemäß Anspruch 1 sowie durch ein Modulladegerät zum Laden und/oder Entladen eines Zellmoduls eines Fahrzeugakkus mit einer Diagnosefunktion gemäß Anspruch 9 gelöst. Vorteilhafte Weiterbildungen der Erfindung sind in den abhängigen Ansprüchen angegeben.

Das erfindungsgemäße Verfahren zum Analysieren der Kontaktbelegung eines Kontaktelements eines Zellmoduls für einen Fahrzeugakku zum nachfolgenden Laden oder Entladen einzelner Zellen des Zellmoduls mittels eines Modulladegeräts weist als Verfahrensschritte zunächst ein Verbinden eines mit dem Kontaktelement des Zellmoduls korrespondierenden Kontaktelements einer Diagnoseeinheit zum Herstellen einer elektrischen Verbindung zu jedem der Kontakte des Zellmoduls auf, wobei nachfolgend wenigstens eine Spannungsmessung eines Kontaktes gegen alle anderen einzelnen Kontakte des Kontaktelements des Zellmoduls und Abspeichern der den Kontakten zugeordneten Spannungswerte durchgeführt wird. Auf Basis der den Kontakten zugeordneten Spannungswerten wird dann die Kontaktbelegung des Kontaktelements bezüglich der Verbindung zu den einzelnen Zellen des Zellmoduls ermittelt und schließlich wird dann das Zellmodul geladen oder entladen.

Das erfindungsgemäße Modulladegerät zum Laden und/oder zum Entladen eines Zellmoduls eines Fahrzeugakkus mit einer Diagnosefunktion der Kontaktbelegung eines Kontaktelements des Zellmoduls weist ein mit dem Kontaktelement des Zellmoduls korrespondierendes Kontaktelement zum Herstellen einer elektrischen Verbindung zu jedem der Kontakte des Zellmoduls auf, wobei jeder Kontakt jeweils über einen Schalter einer elektronischen Schalteinheit mit zwei Diagnoseleitungen des Modulladegeräts verbunden ist, sodass jeder Kontakt über die beiden Schalter wenigstens mit der ersten oder mit der zweiten Diagnoseleitung verbunden werden kann. Weiterhin weist das Modulladegerät eine Spannungsmesseinheit zum Messen der Spannungsdifferenz zwischen den einzelnen jeweils mit einer der Diagnoseleitungen verbundenen Kontakten und somit den einzelnen Zellen des Zellmoduls, eine Diagnoseeinheit zum Ermitteln der Kontaktbelegung des Kontaktelements bezüglich der Verbindung zu den einzelnen Zellen des Zellmoduls sowie eine Lade- und/oder Entladeeinheit des Zellmoduls.

Die Erfinder haben erkannt, dass es vorteilhaft ist, die Belegung der Kontakte eines Kontaktelements eines Zellmoduls vor einem Lade- und/oder Entladevorgang zu prüfen, um somit eine Fehlladung oder eine Beschädigung des Fahrzeugakkus zu vermeiden. Zudem ermöglicht ein Modulladegerät mit einer Diagnoseeinheit in vorteilhafter Weise das Laden und/oder Entladen zahlreicher verschiedener Zellmodule, sodass an einem Standort zur Reparatur von Fahrzeugakkus nur ein einziges Modulladegerät für verschiedene Fahrzeuge oder Fahrzeugtypen notwendig ist.

Das Modulladegerät ist grundsätzlich gebildet, die einzelnen Zellen, insbesondere alle Zellen, eines Zellmoduls eines Fahrzeugakkus laden und/oder entladen zu können. Darüber hinaus kann das Modulladegerät erfindungsgemäß auch die Spannung zwischen zwei Kontakten und somit die Zellspannung bzw. die Differenz zwischen den Spannungen zweier Kontakte messen. Darüber hinaus ist es grundsätzlich mittels des Modulladegeräts auch möglich, einzelne Zellen, insbesondere Zellen mit abweichenden Spannungswerten, über die jeweiligen ermittelten Kontakte mittels des Modulladegeräts zum Angleichen des Spannungsniveaus aller Zellen des Zellmoduls aneinander gezielt zu laden oder zu entladen. Bevorzugt weist das Modulladegerät noch weitere Funktionen, insbesondere zur Analyse und/oder zur Diagnose eines Zellmoduls auf, wie beispielsweise eine Widerstandsmessung von im Zellmodul angeordneten Widerständen oder dem Auslesen von Sensoren im oder am Zellmodul. Weiterhin weist das Modulladegerät bevorzugt wenigstens eine Schnittstelle zum Datenaustausch mit einer weiteren Steuerung und/oder Recheneinheit auf, wobei eine Datenübertragung dabei sowohl kabelgebunden, als auch per Funk bzw. kabellos erfolgen kann.

Das Zellmodul weist grundsätzlich mehrere Einzelzellen auf, wobei die Anzahl der Einzelzellen eines Zellmoduls grundsätzlich beliebig gewählt sein kann. Bevorzugt weist das Zellmodul jedoch wenigstens 16, besonders bevorzugt wenigstens 40, ganz besonders bevorzugt wenigstens 50 und insbesondere bevorzugt genau 56 Einzelzellen auf. Aus der Anzahl der Zellen, der Einzelzellspannung sowie deren Verschaltung im Zellmodul ergibt sich die Gesamtspannung des Zellmoduls, sodass die Anzahl der Zellen nicht frei wählbar, sondern abhängig von der erwünschten Gesamtspannung ist. Dabei ist diese Gesamtspannung grundsätzlich frei wählbar, wobei jedoch eine Spannung von 400 V oder von 800 V bevorzugt wird. Die Einzelzellen in dem Zellmodul können grundsätzlich beliebig miteinander verbunden sein, wobei eine Anordnung mehrerer, insbesondere aller Zellen eines Zellmoduls in Serie bevorzugt wird, insbesondere um die geforderte Spannung bereitstellen zu können.

Der Fahrzeugakku kann zwar grundsätzlich auch nur ein Zellmodul aufweisen, jedoch ist gewöhnlich eine deutlich höhere Speicherkapazität erforderlich, sodass zahlreiche Zellmodule im Fahrzeugakku verbaut und dabei insbesondere in Serie zueinander verschaltet sind. Um jedoch einen Fahrzeugakku besser bauen und/oder reparieren zu können, sind wenigstens die einzelnen Zellmodule im Fahrzeugakku austauschbar, um bei einem Defekt eines Zellmoduls bzw. einzelner Zellen eines Zellmoduls die übrigen, noch fehlerfreien Zellmodule weiterverwenden zu können.

In dem Zellmodul ist bevorzugt jede einzelne Zelle und/oder die Verbindung zwischen zwei in Serie angeordneten Zellen kontaktierbar nach Außen geführt, sodass die jeweilige Zellspannung vom Äußeren des Zellmoduls und besonders bevorzugt an einem Kontakt eines entsprechenden Kontaktelements, insbesondere eines Steckers, messbar ist.

Das Kontaktelement ist grundsätzlich ein Bauteil mit mehreren Kontakten zu jeweils einem elektrischen Leiter und bevorzugt zu jeder der Zellen des Zellmoduls und/oder zu weiteren Bauteilen des Zellmoduls, insbesondere zu Kodierwiderständen, temperaturanhängigen Widerständen, Temperatursensoren, weiteren Sensoren und/oder anderen elektrischen Bauteilen. Dabei ist das Kontaktelement des Zellmoduls bevorzugt ein Stecker und besonders bevorzugt ein standardisierter Stecker. Weiterhin bevorzugt ist der Stecker Teil eines Zell-Kontaktierungs-Systems und insbesondere ein 108-poliger Stecker eines Zell-Kontaktierungs-Systems. Weiterhin bevorzugt sind die Hauptstromanschlüsse des Zellmoduls separat von dem Kontaktelement des Zellmoduls zum Kontaktieren der einzelnen Zellen gebildet.

Das Verfahren zur Analyse der Kontaktbelegung wird bevorzugt nach jedem Zellaustausch im Zellmodul und/oder nach jedem Zellmodulaustausch in einem Fahrzeugakku durchgeführt. Besonders bevorzugt wird das Verfahren zur Analyse der Kontaktbelegung vor jedem Lade- und/oder Entladevorgang eines Zellmoduls oder eines Fahrzeugakkus mittels eines Modullade- und -entladegeräts durchgeführt.

Erfindungsgemäß erfolgen wenigstens Spannungsmessungen zwischen einem ersten Kontakt und allen weiteren Kontakten des Kontaktelements des Zellmoduls. Die Messung von zwei Kontakten gegeneinander erfolgt dabei derart, dass der eine Kontakt an die erste Diagnoseleitung, insbesondere mittels des einen Schalters der elektronischen Schalteinheit, angeschlossen wird und dann der andere Kontakt, insbesondere mittels des anderen Schalters der zum Kontakt zugehörigen Schalteinheit, mit der zweiten Diagnoseleitung verbunden wird, sodass eine Spannungsdifferenz zwischen den beiden Diagnoseleitungen messbar ist. Ebenfalls erfindungsgemäß verbindet ein Schalter der jeweiligen elektronischen Schalteinheit den jeweiligen Kontakt mit der ersten Diagnoseleitung und der zweite Schalter verbindet den jeweiligen Kontakt mit der zweiten Diagnoseleitung.

Das Schalten der elektronischen Schalteinheit jedes Kontaktes erfolgt bevorzugt über eine zentrale Steuereinheit des Modulladegeräts oder eines Diagnosemoduls des Modulladegeräts. Jedoch ist grundsätzlich auch denkbar, die elektronischen Schalteinheiten über eine externe Steuereinheit anzusteuern oder eine interne Steuereinheit mit einer externen Steuereinheit zu verbinden.

Die beiden Diagnoseleitungen sind grundsätzlich mit der Diagnoseeinheit verbunden und/oder eine Spannungsmessung erfolgt bevorzugt grundsätzlich zwischen den beiden Diagnoseleitungen. Weiterhin sind alle Kontakte über einen Schalter der elektronischen Schalteinheit mit der ersten Diagnoseleitung und über einen zweiten Schalter der elektronischen Schalteinheit mit der zweiten Diagnoseleitung verbunden. Weiterhin bevorzugt sind die Diagnoseleitungen und/oder der Ausgang der Spannungsmesseinheit mit einem Analog-Digital-Wandler und besonders bevorzugt an einem 24bitAnalog-Digital-Wandler angeschlossen. Ebenfalls bevorzugt ist der Analog-Digital-Wandler galvanisch getrennt mit einer Steuerung zum Datenaustausch verbunden, wobei die Kommunikation besonders bevorzugt über SPI erfolgt. Weiterhin bevorzugt ist der Analog-Digital-Wandler und/oder die Spannungsmesseinheit mit den Diagnoseleitungen über einen Spannungsteiler verbunden. Die Diagnoseeinheit umfasst bevorzugt eine Konstantstromquelle zum Aufschalten eines Konstantstroms auf ein Kontaktpaar zum Messen eines Widerstandes.

Die Spannungsmesseinheit kann grundsätzlich beliebig gebildet sein und ist bevorzugt vorgesehen, Spannungsdifferenzen von bis zu ± 300 V, besonders bevorzugt bis zu ± 400 V, ganz besonders bevorzugt bis zu ± 800 V und insbesondere bevorzugt bis zu ± 1 kV zu messen.

Eine bevorzugte Ausgestaltung des erfindungsgemäßen Verfahrens zum Analysieren der Kontaktbelegung sieht vor, dass beim Durchführen der Spannungsmessung jeder einzelne Kontakt gegen jeden weiteren Kontakt des Kontaktelements des Zellmoduls gemessen wird und die jeweilige Spannungsdifferenz der beiden jeweils gemessenen Kontakte zur Ermittlung der Kontaktbelegung gespeichert wird, wodurch in besonders einfacher Weise eine möglichst umfassende Analyse der Kontaktierung des Kontaktelements vorgenommen wird. Bei der Spannungsmessung wird insbesondere ermittelt, ob der jeweilige Kontakt gegenüber den anderen Kontakten eine Spannung bzw. eine Spannungsdifferenz aufweist. Soweit dies der Fall ist, ist der Kontakt mit einer Zelle des Zellmoduls verbunden. Kontakte ohne Spannungsdifferenz sind entweder nicht belegt oder weisen eine andere Funktion auf, die im Rahmen einer weiteren Messung und in anderer Weise ermittelt werden kann.

Dabei ist eine Messung aller Kontakte gegeneinander sinnvoll, da eine Messung nur gegen einen Kontakt zu keinem zuverlässigen Ergebnis führt, da die Kontakte des Kontaktelements willkürlich belegt sein können. So kann das erste ausgewählte Kontaktelement, gegen das alle weiteren Kontakte gemessen werden, nicht belegt sein, sodass hier keine sinnvolle Spannungsmessung möglich ist. Darüber hinaus führt beispielsweise auch eine Messung eines Kontaktes für die Gesamtspannung des Zellmoduls gegen den Kontakt der letzten Zelle einer Serienanordnung von Zellen in einem Zellmodul zu einem Differenzwert von Null, sodass hier nicht unterschieden werden kann, ob der Kontakt für die Gesamtspannung oder ein nicht belegter Kontakt gefunden wurde. Wird jedoch dann der jeweilige Kontakt gegen einen oder mehrere weitere Kontakte gemessen, kann diese Unterscheidung vorgenommen werden. Zudem kann auf diese Weise der Kontakt bzw. können die Kontakte für die Gesamtspannung des Zellmoduls gefunden werden, da hier die größte Spannung anliegt.

Gemäß einer vorteilhaften Weiterbildung des erfindungsgemäßen Verfahrens zum Analysieren der Kontaktbelegung werden beim Durchführen der Spannungsmessung zunächst alle weiteren Kontakte gegen einen ersten einzelnen Kontakt in einer jeweiligen ersten Messung gemessen und nachfolgend werden dann nur die Kontakte gegen einen zweiten einzelnen Kontakt in einer weiteren Messung gemessen, für die bei der ersten Messung keine Spannung messbar war bzw. eine Spannung von Null gemessen wurde. Besonders bevorzugt wird dies fortgesetzt, d.h. solange eine weitere Messung nach wie vor eine Spannungsdifferenz für den jeweiligen Kontakt von Null ergibt, wird dieser Kontakt gegen weitere Kontakte gemessen, bis ein Spannungswert bzw. eine Spannungsdifferenz von ungleich Null gefunden wurde oder der jeweilige Kontakt gegen alle übrigen Kontakte gemessen wurde und somit - beim Ausbleiben einer Spannungsdifferenz - der Kontakt als nicht belegt bestätigt wurde.

Bei einer bevorzugten Ausgestaltung des erfindungsgemäßen Verfahrens zum Analysieren der Kontaktbelegung werden die den Kontakten zugeordneten Spannungswerte zum Ermitteln der Kontaktbelegung des Kontaktelements nach ihrer Reihenfolge der absoluten Spannungswerte bzw. Spannungsdifferenzwert und/oder in der Reihenfolge der zueinander kleinsten Differenzspannung ungleich Null sortiert, um so die Kontakte in der Reihenfolge ihres Anschlusses an die einzelnen, in Serie angeordneten Einzelzellen des Zellmoduls zu identifizieren. Auch eine Sortierung jeweils nach dem Inkrement bzw. der Differenz der bekannten Einzelzellenspannung ist zusätzlich oder alternativ denkbar. Da eine Messung jeweils gegen einen einzelnen Kontakt erfolgt, wirdbevorzugt zudem die Polarität und/oder der Betrag der Spannungsdifferenz beim Sortieren und/oder bei dem Ermitteln der Kontaktbelegung berücksichtigt.

Eine deutliche Verbesserung des erfindungsgemäßen Verfahrens zum Analysieren der Kontaktbelegung kann noch dadurch erreicht werden, dass nach der Spannungsmessung auch eine Widerstandsmessung wenigstens eines Teils der Kontakte und bevorzugt jedes einzelnen Kontaktes gegen jeden der weiteren Kontakte durchgeführt wird, wozu ein Konstantstrom jeweils auf ein Paar von gegeneinander zu messenden Kontakten aufgeschaltet wird und anschließend der Widerstand zwischen beiden Kontakten gemessen wird. Das Messen des Widerstandes erfolgt dabei bevorzugt mittels der Diagnoseeinheit. Das Aufschalten des Konstantstroms kann über die Diagnoseleitungen und/oder mittels der elektronischen Schalteinheit erfolgen. Dabei wird bevorzugt - genau wie bei der Spannungsmessung - der erste Kontakt mittels des ersten Schalters der zugehörigen elektronischen Schalteinheit mit der ersten Diagnoseleitung und der zweite Kontakt wird über den zweiten Schalter der zugehörigen elektronischen Schalteinheit mit der zweiten Diagnoseleitung verbunden.

Obwohl das Messen der Widerstände aus beliebigen Gründen erfolgen kann, ist eine solche Messung besonders sinnvoll, um die Kontakte bzw. die Kontaktpaare von temperaturabhängigen Widerständen, insbesondere von Heißleitern bzw. NTC-Widerständen, zur Ermittlung der Zelltemperatur zu finden. Ein Zellmodul kann dabei beliebig viele solcher temperaturabhängigen Widerstände aufweisen, wobei typischerweise 1-6 dieser Widerstände in einem Zellmodul angeordnet sind. Die einzelnen Widerstände eines Zellmoduls und insbesondere die temperaturabhängigen Widerstände können dabei jeweils mit zwei einzelnen Kontakten verbunden sein oder aber sich paarweise, in Gruppen oder insgesamt einen Kontakt teilen und einen jeweiligen zweiten Kontakt aufweisen. Zudem werden typischerweise die Zellmodule über wenigstens einen Kodierwiderstand identifiziert, der Informationen zum Zellmodul, wie beispielsweise die Generation und/oder den Typ des Akkus bzw. des Zellmoduls, markiert.

Um jedoch die Widerstandsmessung des Kontaktelements deutlich zu beschleunigen, sieht eine Weiterbildung des erfindungsgemäßen Verfahrens zum Analysieren der Kontaktbelegung vor, dass eine Widerstandsmessung nur bei Kontakten durchgeführt wird, bei denen bei der vorausgegangenen Spannungsmessung keine Spannung bzw. eine Spannung von Null gemessen wurde, wodurch die Zellen nicht mitgemessen werden und/oder spezifisch nach mit den jeweiligen Kontakten verbundenen Widerständen und/oder Sensoren gesucht wird.

Obwohl es grundsätzlich ausreichend wäre, die Spannung und/oder den Widerstand nur zum Analysieren der Kontaktbelegung direkt nach dem Verbinden des Modulladegeräts zu messen, ist es jedoch bevorzugt auch während des Ladens und/oder des Entladens eine Messung der Spannung und/oder des Widerstandes vorzunehmen, wobei besonders bevorzugt nur eine Messung der Spannung und/oder des Widerstandes der für die ladende oder entladende Zelle relevanten Kontakte erfolgt. Das Messen während des Ladens und/oder des Entladens kann dabei periodisch oder kontinuierlich erfolgen. Zudem kann das Messen anlassbezogen erfolgen, beispielsweise in Form einer Spannungsmessung im Fall einer bei einer periodisch vorgenommenen Widerstandsmessung festgestellten Temperaturabweichung oder Grenztemperaturüberschreitung.

Um je nach erforderlicher Lade- bzw. Entladeleistung einen besseren Wirkungsgrad in einem Teillastbereich zu erreichen, sodass die aktiven Leistungsversorgungen und/oder Entladeeinheiten stets in einem besonders vorteilhaften Leistungsbereich betrieben werden können, sieht eine bevorzugte Ausgestaltung des erfindungsgemäßen Verfahrens vor, dass während des Ladens und/oder des Entladens bedarfsweise mehrere, insbesondere parallel zueinander angeordnete Leistungsversorgungen und/oder Entladeeinheiten zugeschaltet oder abgeschaltet werden. Die Leistungsversorgungen sind dabei bevorzugt Leistungsnetzteile und besonders bevorzugt Schaltnetzteile.

Bei dem Modulladegerät zum Laden und/oder Entladen eines Zellmoduls ist eine Ausgestaltung bevorzugt, bei der die elektronische Schalteinheit jeweils wenigstens einen, bevorzugt zwei optoelektronisch galvanisch getrennte Schalter (OptoMOS) aufweist und ganz besonders bevorzugt daraus gebildet ist. Zudem ist bevorzugt, dass die elektronische Schalteinheit derart gebildet ist und/oder derart angesteuert wird, dass ein Aktivieren beider Schalter zugleich ausgeschlossen ist. Dabei kann ein Öffnen bzw. Aktivieren beider Schalter zugleich sowohl durch die Hardware selber, als auch zusätzlich oder alternativ elektronisch bzw. durch die Steuersoftware ausgeschlossen sein. Insbesondere bei einer Verwendung von optoelektronisch galvanisch getrennten Schaltern ist dies bereits durch die verwendeten Schalter ausgeschlossen. Ein Schließen beider Schalter des OptoMOS führt zu einem internen Kurzschluss, der jedoch grundsätzlich dazu verwendet werden kann, die Funktion des Schalters selber, die Funktion einer Konstantstromquelle und/oder des Offsets des Analog-Digital-Wandlers zu prüfen.

Mehrere Ausführungsbeispiele von Modulladegeräten sowie des Verfahrens zur Verwendung werden nachfolgend mit Bezug auf die Zeichnungen näher erläutert. In den Figuren zeigen:
- Fig. 1: eine schematische Schaltzeichnung einer ersten Ausführung einer Diagnoseeinheit eines Modulladegeräts, und
- Fig. 2: eine schematische Schaltzeichnung einer zweiten Ausführung einer Diagnoseeinheit eines Modulladegeräts.

Das Modulladegerät ist grundsätzlich zum Laden und Entladen einzelner Zellen eines Zellmoduls für einen Fahrzeugakku vorgesehen. Dazu weist das Modulladegerät neben einer Lade- und Entladeeinheit eine Diagnoseeinheit 2 auf, mittels der die Kontaktbelegung eines 108 poligen ZKS-Steckers eines Zellmoduls analysiert werden kann.

Dazu weist das Modulladegerät ein als Buchse für den ZKS-Stecker gebildetes Kontaktelement 1 auf, das jeweils einen Kontakt 3 mit jedem der Kontakte des ZKS-Steckers in elektrische Verbindung bringt. Ein Teil der Kontakte 3 ist somit mit jeweils einer Zelle des Zellmoduls verbunden, während weitere Kontakte 3 mit weiteren Komponenten des Zellmoduls, wie beispielsweise Kodierwiderständen und 1-6 temperaturabhängigen Widerständen als Temperatursensoren verbunden sind.

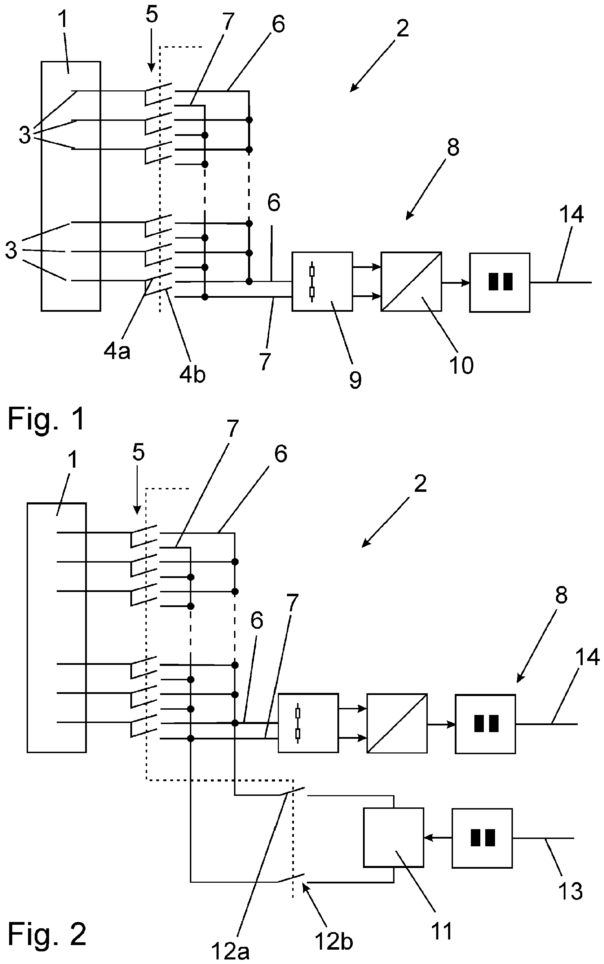

Um die an den einzelnen Kontakten 3 anliegende elektrische Spannung sowie den jeweiligen Widerstand messen zu können, weist die Diagnoseeinheit 2 zwei Diagnoseleitungen 6, 7 auf, die jeweils mit einer Spannungsmesseinheit 8 verbunden sind. Die Spannungsmesseinheit 8 weist dabei einen Spannungsteiler 9 und einen A/D-Wandler 10 sowie einen Stecker zu einer SPI-Datenleitung 14 auf. Um die Spannungen zwischen jeweils zwei Kontakten 3 messen zu können, ist jeder der Kontakte 3 mit der ersten und der zweiten Diagnoseleitung 6,7 über jeweils einen Schalter 4a, b einer elektronischen Schalteinheit 5 verbunden (siehe Fig. 1). Als Schalteinheit 5 werden optoelektronisch galvanisch getrennte Schalter verwendet. Dabei wird sichergestellt, dass ein jeweiliger Kontakt 3 nur entweder mit der ersten Diagnoseleitung 6 oder mit der zweiten Diagnoseleitung 7, nicht jedoch mit beiden Diagnoseleitungen 6,7 zugleich verbunden werden kann. Zur Spannungsmessung werden dann mittels den elektronischen Schalteinheiten 5 jeweils zwei Kontakte 3 gegeneinander verschaltet und gemessen.

Eine zweite Ausgestaltung des Modulladegeräts erlaubt zudem eine Messung der Widerstände der einzelnen Kontakte 3, wozu eine Konstantstromquelle 11 vorgesehen ist, die über Stromschalter 12a, b mit den beiden Diagnoseleitungen 6,7 verbunden werden kann. Die Konstantstromquelle 11 ist dabei an eine externe Versorgung 13 angeschlossen. Entsprechend kann durch das Verbinden einzelner Kontakte mit den stromführenden Diagnoseleitungen 6,7 mittels der elektronischen Schalteinheit 5 eine Widerstandsmessung des jeweiligen Kontaktes 3 vorgenommen werden.

Sobald die Kontaktbelegung des ZKS-Steckers bekannt ist, kann das Zellmodul dann geladen oder entladen werden.

Bei dem Verfahren zum Analysieren der Kontaktbelegung des ZKS-Steckers, wird zunächst ein erster Kontakt 3 mit der ersten Diagnoseleitung 6 mittels der elektronischen Schalteinheit 5 verbunden. Nachfolgend werden dann nacheinander alle weiteren Kontakte 3 einzeln mit der zweiten Diagnoseleitung 7 verbunden und die Spannung jeweils gemessen sowie dem jeweiligen Kontakt 3 bzw. Kontaktpaar zugeordnet gespeichert.

Alle Kontakte 3, für die bei dieser ersten Messung eine Spannung von Null gemessen wurde, werden dann gegen einen weiteren Kontakt 3 gemessen, wozu der erste Kontakt 3 von der ersten Diagnoseleitung 6 getrennt und ein anderer Kontakt 3 mit der ersten Diagnoseleitung 6 mittels der elektronischen Schalteinheit 5 verbunden wird. Nachfolgend werden dann alle Kontakte 3 mit einem bisher gemessenen Spannungswert von Null mit der zweiten Diagnoseleitung 7 verbunden und gemessen. Die Ergebnisse werden abermals den Kontakten 3 zugeordnet gespeichert. Werden nach wie vor Spannungswerte von Null gemessen, wird der Vorgang beliebig oft mit einem anderen, an die erste Diagnoseleitung 6 angeschlossenen Kontakt 3 wiederholt, bis alle Kontakte 3 durchgemessen sind.

Wenn schließlich alle Kontakte 3 gemessen sind, werden die gemessenen Spannungswerte analysiert und dazu in aufsteigender Reihenfolge sortiert, wobei die Zuordnung zu den Kontakten 3 beachtet wird. Auf diese Weise kann die Reihenfolge der Zellen im Zellmodul über die jeweilig zugehörigen Kontakte 3 gefunden werden und die Kontaktbelegung im Hinblick auf die einzelnen Zellen im Zellmodul ist bekannt.

Da weiterhin bekannt ist, dass das Zellmodul auch Kodierwiderstände sowie temperaturabhängige Widerstände als Temperatursensoren enthält, wird nachfolgend eine Konstantstromquelle 11 an die beiden Diagnoseleitungen 6, 7 angeschlossen und abermals mittels der elektronischen Schalteinheiten 5 die einzelnen Kontakte 3 gegeneinander gemessen, wobei nur eine Messung der Kontakte 3 erfolgt, für die eine Spannung von Null gemessen wurde, da an diesen Kontakten 3 keine Zelle angeschlossen sein kann. Nachfolgend sind alle Widerstände bekannt.

Anschließend kann dann gezielt über die jeweiligen Kontakte 3 ein Laden oder Entladen einzelner Zellen, insbesondere von Zellen mit einer von den übrigen Zellen abweichenden Spannung, vorgenommen werden, wobei zugleich bevorzugt mittels der Diagnoseeinheit 2 periodisch die Spannung kontrolliert und über die temperaturabhängigen Widerstände die Temperatur im Zellmodul überwacht wird. Generell kann jedoch auch ein Laden oder Entladen des gesamten Zellmoduls mit allen Zellen gemeinsam erfolgen.

### Bezugszeichenliste

- 1: Kontaktelement
- 2: Diagnoseeinheit
- 3: Kontakt
- 4a ,b: Schalter
- 5: elektronische Schalteinheit
- 6: erste Diagnoseleitung
- 7: zweite Diagnoseleitung
- 8: Spannungsmesseinheit
- 9: Spannungsteiler
- 10: A/D-Wandler
- 11: Konstantstromquelle
- 12a, b: Stromschalter
- 13: Versorgung
- 14: SPI-Schnittstelle

## Patentansprüche

1. Verfahren zum Analysieren der Kontaktbelegung eines Kontaktelements eines Zellmoduls für einen Fahrzeugakku zum nachfolgenden Laden oder Entladen einzelner Zellen des Zellmoduls mittels eines Modulladegeräts, mit den Schritten:
- Verbinden eines mit dem Kontaktelement des Zellmoduls korrespondierenden Kontaktelements (1) einer Diagnoseeinheit (2),
- Durchführen wenigstens einer Spannungsmessung eines Kontaktes (3) gegen alle anderen einzelnen Kontakte (3) des Kontaktelements (1) und Abspeichern der den Kontakten (3) zugeordneten Spannungswerten,
- Ermitteln der Kontaktbelegung des Kontaktelements (1) bezüglich der Verbindung zu den einzelnen Zellen des Zellmoduls auf Basis der den Kontakten (3) zugeordneten Spannungswerte,
- Laden oder Entladen des Zellmoduls.

2. Verfahren zum Analysieren der Kontaktbelegung nach Anspruch 1, **dadurch gekennzeichnet, dass** beim Durchführen der Spannungsmessung jeder einzelne Kontakt (3) gegen jeden weiteren Kontakt (3) des Kontaktelements (1) des Zellmoduls gemessen wird und die jeweilige Spannungsdifferenz der beiden jeweils gemessenen Kontakte (3) zur Ermittlung der Kontaktbelegung gespeichert wird.

3. Verfahren zum Analysieren der Kontaktbelegung nach Anspruch 1 oder 2, **dadurch gekennzeichnet, dass** beim Durchführen der Spannungsmessung zunächst alle weiteren Kontakte (3) gegen einen ersten einzelnen Kontakt (3) in einerjeweiligen ersten Messung gemessen werden und nachfolgend nur die Kontakte (3) gegen einen zweiten einzelnen Kontakt (3) in einer weiteren Messung gemessen werden, für die bei der ersten Messung eine Spannung von Null gemessen wurde.

4. Verfahren zum Analysieren der Kontaktbelegung nach wenigstens einem der vorhergehenden Ansprüche, **dadurch gekennzeichnet, dass** die den Kontakten (3) zugeordneten Spannungswerte zum Ermitteln der Kontaktbelegung des Kontaktelements (1) nach ihrer Reihenfolge der absoluten Spannungswerte oder in der Reihenfolge der zueinander kleinsten Differenzspannung ungleich Null sortiert werden, um so die Kontakte (3) in der Reihenfolge ihres Anschlusses an die einzelnen, in Serie angeordneten Einzelzellen des Zellmoduls zu finden.

5. Verfahren zum Analysieren der Kontaktbelegung nach wenigstens einem der vorhergehenden Ansprüche, **dadurch gekennzeichnet, dass** nach der Spannungsmessung auch eine Widerstandsmessung wenigstens eines Teils der Kontakte (3) und bevorzugt jedes einzelnen Kontaktes (3) gegen jeden der weiteren Kontakte (3) durchgeführt wird, wozu ein Konstantstrom jeweils auf ein Paar von gegeneinander zu messenden Kontakten (3) aufgeschaltet wird und anschließend der Widerstand zwischen beiden Kontakten (3) gemessen wird.

6. Verfahren zum Analysieren der Kontaktbelegung nach wenigstens einem der vorhergehenden Ansprüche, **dadurch gekennzeichnet, dass** eine Widerstandsmessung nur bei Kontakten (3) durchgeführt wird, bei denen bei der vorausgegangenen Spannungsmessung keine Spannung bzw. eine Spannung von Null gemessen wurde.

7. Verfahren zum Analysieren der Kontaktbelegung nach wenigstens einem der vorhergehenden Ansprüche, **dadurch gekennzeichnet, dass** während des Ladens und/oder des Entladens eine Messung der Spannung und/oder des Widerstandes vorgenommen wird, wobei bevorzugt nur eine Messung der Spannung und/oder des Widerstandes der für die ladende oder entladende Zelle relevanten Kontakte (3) erfolgt.

8. Verfahren zum Analysieren der Kontaktbelegung nach wenigstens einem der vorhergehenden Ansprüche, **dadurch gekennzeichnet, dass** während des Ladens und/oder des Entladens bedarfsweise mehrere, insbesondere parallel zueinander angeordnete Leistungsversorgungen und/oder Entladeeinheiten zugeschaltet oder abgeschaltet werden.

9. Modulladegerät zum Laden und Entladen eines Zellmoduls eines Fahrzeugakkus mit einer Diagnosefunktion der Kontaktbelegung eines Kontaktelements des Zellmoduls, mit
- einem mit dem Kontaktelement des Zellmoduls korrespondierenden Kontaktelement (1) zum Herstellen einer elektrischen Verbindung zu jedem der Kontakte des Zellmoduls, wobei
- jeder Kontakt (3) jeweils über einen Schalter (4a,b) einer elektronischen Schalteinheit (5) mit zwei Diagnoseleitungen des Modulladegeräts verbunden ist, sodass jeder Kontakt (3) über die beiden Schalter (4a,b) mit der ersten oder mit der zweiten Diagnoseleitung (6,7) verbunden werden kann,
- einer Spannungsmesseinheit (8) zum Messen der Spannungsdifferenz zwischen den einzelnen jeweils mit einer der Diagnoseleitungen (6,7) verbundenen Kontakten (3),
- einer Diagnoseeinheit (2) zum Ermitteln der Kontaktbelegung des Kontaktelements (1) bezüglich der Verbindung zu den einzelnen Zellen des Zellmoduls sowie
- einer Lade- und/oder Entladeeinheit zum Anpassen der Zellspannung des Zellmoduls.

10. Modulladegerät zum Laden und Entladen eines Zellmoduls nach Anspruch 9, **dadurch gekennzeichnet, dass** die elektronische Schalteinheit (5) aus einem optoelektronisch galvanisch getrennten Schalter gebildet ist.

11. Modulladegerät zum Laden und Entladen eines Zellmoduls nach Anspruch 9 oder 10, **dadurch gekennzeichnet, dass** die elektronische Schalteinheit (5) derart gebildet ist und/oder derart angesteuert wird, dass ein Aktivieren beider Schalter (4a,b) zugleich ausgeschlossen ist.
